Europäisches Patentamt

European Patent Office

Office européen des brevets

(11) Numéro de publication: **0 357 486**
**A1**

## DEMANDE DE BREVET EUROPEEN

(21) Numéro de dépôt: 89402283.9

(22) Date de dépôt: 11.08.89

(51) Int. Cl.5: **H 01 P 11/00**
H 01 P 3/08, H 05 K 3/40

(30) Priorité: 30.08.88 FR 8811356

(43) Date de publication de la demande:
07.03.90 Bulletin 90/10

(84) Etats contractants désignés: **DE GB IT NL**

(71) Demandeur: **THOMSON-CSF**
**51, Esplanade du Général de Gaulle**
**F-92800 Puteaux (FR)**

(72) Inventeur: **Roche, Pascal**
**THOMSON-CSF SCPI Cédex 67**
**F-92045 Paris la Défense (FR)**

**Muoy Yin Hak**
**THOMSON-CSF SCPI Cédex 67**
**F-92045 Paris la Défense (FR)**

(74) Mandataire: **Benoit, Monique et al**
**THOMSON-CSF SCPI**
**F-92045 PARIS LA DEFENSE CEDEX 67 (FR)**

(54) Procédé de fabrication d'une zone de connexion pour un circuit hyperfréquence de type triplaque et circuit ainsi obtenu.

(57) L'invention a pour objet un circuit hyperfréquence de type triplaque dont les zones de connexion d'entrée-sortie sont réalisées de la façon suivante :
- rainurage de celui (2) des substrats isolant qui ne porte pas le conducteur central (3) du circuit triplaque, selon le contour de la zone de connexion (Z) souhaitée ;
- collage des deux substrats ;
- protection de l'extérieur de la structure par dépôt électrolytique d'étain-plomb ;
- contre-rainurage du premier substrat selon le contour de la zone de connexion et suppression de la portion du substrat située à l'intérieur de la zone.

FIG_2

21— RAINURAGE

22— PROTECTION CONDUCTEUR CENTRAL

23— COLLAGE DES SUBSTRATS

24— PROTECTION EXTERIEUR

25— CONTRE- RAINURAGE

EP 0 357 486 A1

## Description

## PROCEDE DE FABRICATION D'UNE ZONE DE CONNEXION POUR UN CIRCUIT HYPERFREQUENCE DE TYPE TRIPLAQUE ET CIRCUIT AINSI OBTENU

La présente invention se rapporte au domaine des circuits hyperfréquences du type triplaque, réalisés en technologie circuit imprimé multicouche.

Elle a plus particulièrement pour objet la réalisation d'une zone de connexion d'entrée-sortie pour un tel circuit.

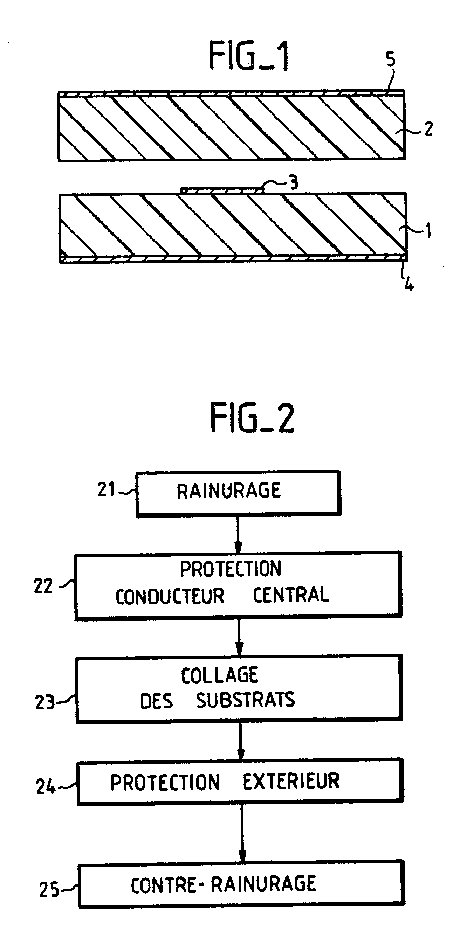

L'invention concerne donc un circuit hyperfréquence du type triplaque, réalisé selon la technologie utilisée pour les circuits imprimés multicouches, c'est-à-dire qu'il comporte, comme représenté en vue en coupe éclatée sur la figure 1 :

    - un premier substrat 1, isolant, dont une face porte une couche conductrice 4 formant plan de masse, et l'autre face porte un motif conducteur 3 formant le conducteur central du circuit triplaque ;

    - un deuxième substrat 2, isolant, dont l'une des faces est destinée à être disposée sur le conducteur central 3 ; l'autre face du substrat 2 porte un dépôt conducteur 5 formant un deuxième plan de masse.

Il apparaît ainsi que le conducteur central 3 est pris en sandwich entre les deux substrats isolants 1 et 2.

Pour connecter un tel circuit aux composants des circuits adjacents, il est nécessaire de réaliser une zone de connexion où le conducteur central 3 sera accessible, c'est-à-dire, en d'autres termes, de mettre le conducteur central à l'air libre.

A cet effet, il est connu de procéder comme suit : on dépose le motif destiné à former le conducteur central sur le substrat 1, dont l'autre face est métallisée. Avant de coller le deuxième substrat 2 sur le premier, on opère une échancrure dans le substrat 2, échancrure dont la géométrie est telle qu'une partie du conducteur central 3 se trouve à l'air libre et qu'on puisse venir y fixer une connexion. Toutefois, cette méthode a des inconvénients. En effet, il est nécessaire de disposer un film protecteur, en général du type vernis, déposé au pinceau, sur les zones ainsi destinées à être mises à l'air libre, de sorte qu'elles ne soient pas détériorées lors des étapes ultérieures de la fabrication ; en fin de fabrication, ce vernis doit bien entendu être retiré, à l'aide de solvants. Cela constitue des opérations supplémentaires qui doivent être très précisément exécutées et qui sont, en outre, difficilement automatisables, donc coûteuses.

La présente invention a pour objet un circuit hyperfréquence dont les zones de connexion d'entrée-sortie sont réalisées de la façon suivante :
- on procède à un rainurage du second substrat mentionné plus haut, selon le contour de la zone à mettre l'air libre ;
- on colle les deux substrats ;
- on dépose une couche de protection de l'extérieur du circuit, un alliage d'étain-plomb par exemple ;
- on procède à un contre-rainurage, c'est-à-dire à un rainurage du deuxième substrat selon le même contour que précédemment mais sur la face opposée, de sorte à supprimer complètement le matériau constituant le substrat selon ce contour, et on enlève la partie de substrat située à l'intérieur du contour.

Plus précisément, l'invention a pour objet un procédé de fabrication d'une zone de connexion pour un circuit hyperfréquence tel que défini par la revendication 1.

D'autres objets, particularités et résultats de l'invention ressortiront de la description suivante, donnée à titre d'exemple non limitatif et illustrée par les dessins annexés, qui représentent :

    - la figure 1, déjà décrite, le schéma vu en coupe d'un circuit du type triplaque ;

    - la figure 2, un schéma illustrant le déroulement du procédé selon l'invention ;

    - les figures 3, a, b et c, des schémas vus en coupe d'un circuit triplaque obtenu par le procédé selon l'invention, lors de différentes étapes de sa fabrication ;

    - les figures 4, a et b, un exemple de circuit triplaque obtenu par le procédé selon l'invention, lors de différentes étapes de sa fabrication.

Sur ces différentes figures, d'une part les mêmes références se rapportent aux mêmes éléments et, d'autre part, l'échelle réelle n'a pas été respectée pour la clarté du dessin.

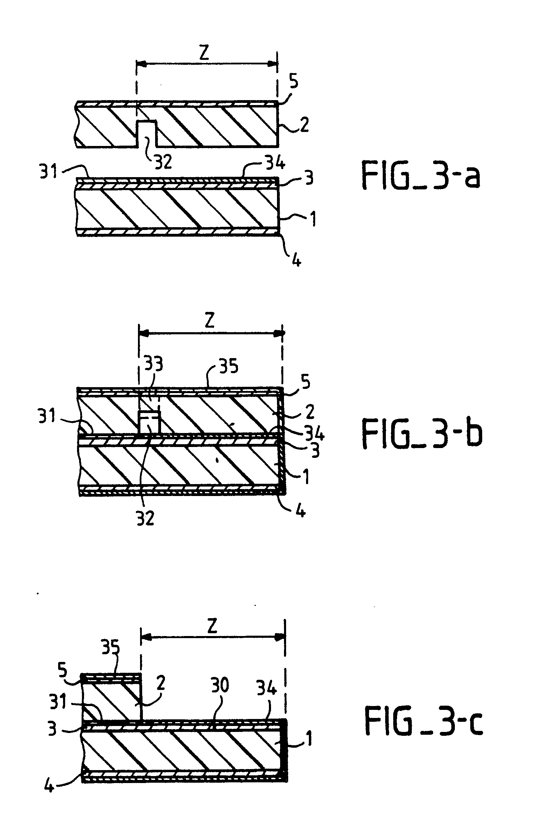

La figure 2 est un schéma illustrant le déroulement des différentes étapes du procédé selon l'invention ; il sera décrit ci-après en liaison avec les figures 3a, 3b et 3c, qui représentent des schémas vus en coupe d'un circuit triplaque obtenu par le procédé selon l'invention, lors des différentes étapes de sa fabrication.

Tout d'abord, lors d'étapes préliminaires non représentées sur les figures, on réalise classiquement deux substrats isolants, les substrats 1 et 2 de la figure 1, en forme de plaquettes, sur l'une des faces desquelles est déposée une couche conductrice en général métallique, par exemple en cuivre, destinée à former les plans de masse 4 et 5 du circuit triplaque.

En outre, un motif conducteur destiné à former le conducteur central 3 du circuit triplaque est déposé sur la deuxième face du substrat 1. Il est généralement métallique, par exemple également en cuivre.

La première étape spécifique au procédé selon l'invention est une étape de rainurage (21, figure 2). Elle consiste à réaliser une rainure, repérée 32 sur la figure 3a, dans la face du substrat 2 qui n'est pas métallisée, selon un contour prédéfini et qui est le contour de la zone (appelée Z, sur les figures 3) dans laquelle on souhaite mettre le conducteur central du circuit triplaque à l'air libre, pour les connexions ultérieures d'entrée-sortie du circuit.

L'étape suivante (22, figure 2) consiste à réaliser la protection contre la corrosion du conducteur central 3 dans la zone Z, où il sera mis à l'air libre. Cette protection est réalisée de préférence par dépôt électrolytique d'une couche d'un alliage d'étain-plomb.

Ce mode de réalisation a pour avantage d'améliorer la qualité et la fiabilité du brasage qui sera réalisé ultérieurement sur le conducteur central 3 pour les connexions d'entrée-sortie.

Cette couche de protection est représentée sur la figure 3a par une couche 34, déposée sur le conducteur central 3 uniquement sur la zone Z.

Dans une variante, non représentée, il est possible de déposer la couche de protection 34 sur la totalité du conducteur central.

Il est à noter que cette étape de protection peut intervenir à un autre moment du procédé de fabrication, par exemple en fin de procédé.

L'étape suivante (23, figure 2) consiste à déposer une couche de colle (31, figure 3a) sur le conducteur central 3, excepté dans la zone de connexion Z, puis à coller les deux substrats de sorte que les deux plans de masse 4 et 5 soient situés à l'extérieur de la structure résultante.

Le dépôt de colle s'effectue de préférence sous forme d'un film mince, dans lequel on a réalisé une lumière correspondant à la zone Z, qu'on dispose sur l'un des substrats.

L'étape suivante (24, figure 2) consiste à déposer une couche de protection contre la corrosion (35, figure 3b) sur l'ensemble de la structure ainsi formée, donc sur les plans de masse 4 et 5 et les tranches des substrats 1 et 2. Cette protection est de préférence réalisée par dépôt électrolytique d'un alliage d'étain-plomb dit brillant et non refondu : en effet, ce matériau présente l'avantage, par rapport à d'autres alliages, d'être très peu oxydable et ce, sans qu'une opération de refusion soit nécessaire.

Un tel mode de protection assure le blindage du circuit et présente différents avantage. Tout d'abord il peut être déposé de façon simple et peu onéreuse sur la totalité des surface extérieures de la structure ; ensuite, n'exigeant pas d'étape de refusion, qui s'opère habituellement au voisinage de 200°C, il évite au circuit d'avoir à subir un choc thermique et, par suite, de présenter d'éventuels décollements des métallisations, difficilement décelables, qui entraînent le rebut du circuit lors des opérations ultérieures d'essais après montage.

L'étape suivante (25, figure 2) consiste à réaliser une contre-rainure, repérée 33 et représenté en pointillés sur la figure 3b, dans le substrat 2 dans lequel avait été réalisée la rainure 32, selon le même contour, c'est-à-dire celui de la zone Z, mais sur l'autre face, c'est-à-dire celle qui porte le plan de masse 5. La hauteur de la contre-rainure 33 est telle qu'elle supprime complètement la matière du substrat 2 et permette à la rainure 32 de déboucher à l'air libre. La partie du substrat 2 située dans la zone Z, qui n'est pas collée, est alors retirée.

Les opérations de rainurage et de contre-rainurage sont effectuées de préférence à l'aide de machines à commande numérique, permettant précision, répétitivité et moindre coût.

L'avantage de procéder d'abord à une rainure puis à une contre-rainure est de permettre une plus grande tolérance sur la hauteur du contre-rainurage. En effet, si on procédait à un rainurage unique, la hauteur de celui-ci devrait être très précisément déterminée pour supprimer la totalité du substrat 2 mais rien que celui-ci, sans entamer les couches 34 et 3.

Il apparaît ainsi qu'on obtient un circuit triplaque sur l'extérieur duquel a été réalisée une couche de protection, présentant une zone (Z) dans laquelle le conducteur central est mis à l'air libre, et sans que soit nécessaire de prévoir une étape de protection de cette zone pendant la fabrication, le substrat 2 lui-même assurant la protection requise.

Dans le cas, fréquent en pratique, où les substrats 1 et 2, appartiennent à des plaques plus grandes, en général de format standardisé, on réalise à la fin du procédé une opération de détourage (non représentée), c'est-à-dire une opération pendant laquelle les parties utiles des substrats 1 et 2 sont séparés du reste des plaques.

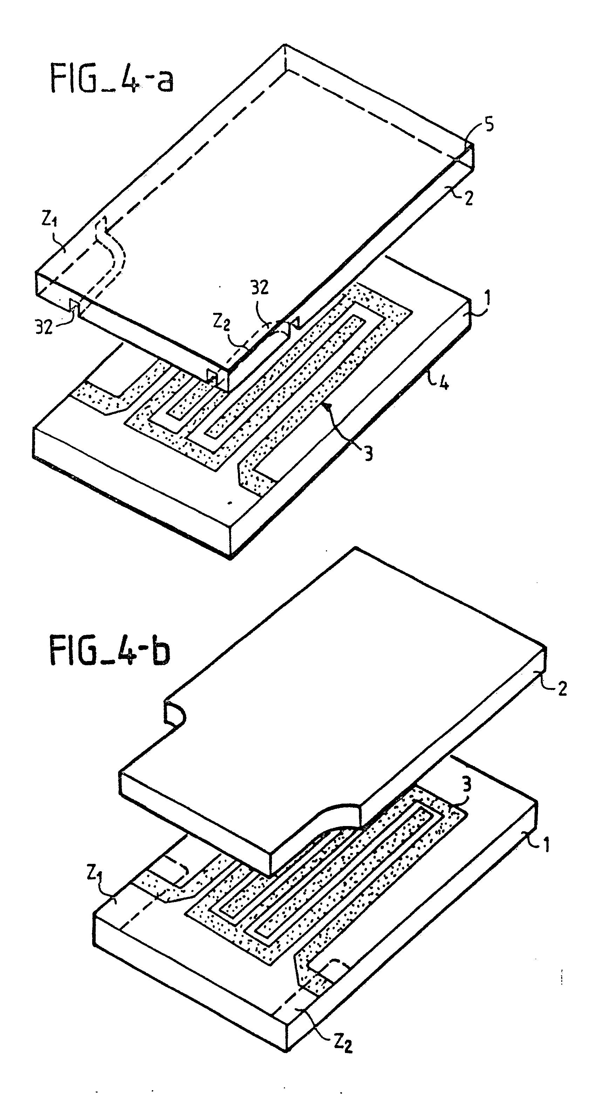

Les figures 4a et 4b représentent un exemple particulier d'un circuit triplaque obtenu par le procédé selon l'invention, lors de différentes phases de sa fabrication.

Sur ces figures, on retrouve les substrats 1 et 2 avec leurs plans de masse, respectivement 4 et 5, ainsi que le substrat 1 portant le motif conducteur 3, par exemple constituant un filtre en forme de peignes interdigités. Pour la clarté de la figure, la surface du conducteur 3 a été pointillée. Les substrats 1 et 2 sont par exemple en PTFE.

Sur la figure 4a, on a représenté deux rainures 32, réalisées dans la face du substrat 2 destinée à venir contre le conducteur 3, et entourant respectivement deux zones $Z_1$ et $Z_2$ dans lesquelles le conducteur central 3 sera mis à l'air libre.

Sur la figure 4b, on a représenté le même circuit en vue éclatée à la fin des opérations, c'est-à-dire lorsque les morceaux de substrat 2 correspondant aux zones $Z_1$ et $Z_2$ ont été enlevés, laissant ainsi apparaître le conducteur 3.

**Revendications**

1) Procédé de fabrication d'une zone de connexion (Z) pour un circuit hyperfréquence du type triplaque, comportant successivement :
- une étape de dépôt d'une première couche conductrice (4) sur une première face d'un premier substrat (1), formant un premier plan de masse du circuit triplaque ;
- une étape de dépôt d'une deuxième couche conductrice (5) sur une première face d'un deuxième substrat (2), formant un deuxième plan de masse du circuit triplaque ;
- une étape de dépôt d'un motif conducteur (3) sur la deuxième face du premier substrat (1), formant le conducteur central du circuit triplaque ;
le procédé étant caractérisé par le fait qu'il comporte en outre, successivement, les étapes suivantes :
- rainurage (21 ; 32) de la deuxième face du deuxième substrat (2) selon le contour de la zone de connexion (Z) à réaliser ;
- collage (23) de la deuxième face du premier substrat (1) sur la deuxième face du deuxième substrat (2) ;

- dépôt (24) d'une couche de protection (35) des surfaces extérieures du circuit ;

- contre-rainurage (25 ; 33) de la première face du deuxième substrat (2) selon le même contour, de sorte à supprimer complètement le matériau formant le deuxième substrat (2) selon ce contour et suppression de la partie du deuxième substrat (2) située à l'intérieur du contour.

2) Procédé selon la revendication 1, caractérisé par le fait qu'il comporte en outre, entre les étapes de rainurage (21) et de collage (23), une étape (22) de dépôt électrolytique sur le conducteur central (3) d'un matériau comportant un alliage d'étain-plomb.

3) Procédé selon l'une des revendications précédentes, caractérisé par le fait que l'étape (24) de protection des surfaces extérieures consiste en un dépôt électrolytique d'un matériau comportant un alliage d'étain-plomb, sur l'ensemble des surfaces extérieures.

4) Procédé selon la revendication 3, caractérisé par le fait que le matériau déposé électrolytiquement est un alliage d'étain-plomb brillant non refondu.

# FIG_1

# FIG_2

21 — RAINURAGE

22 — PROTECTION CONDUCTEUR CENTRAL

23 — COLLAGE DES SUBSTRATS

24 — PROTECTION EXTERIEUR

25 — CONTRE-RAINURAGE

FIG_3-a

FIG_3-b

FIG_3-c

FIG_4-a

FIG_4-b

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | MICROWAVE JOURNAL, vol. 18, no. 8, août 1975, pages 49-51; G.R. TRAUT: "Microwave stripline packaging with UMD's" * Page 50, colonne de gauche, lignes 25-32; page 50, colonne de droite, lignes 1-9; figures 4,10 * | 1,3 | H 01 P 11/00 H 01 P 3/08 H 05 K 3/40 |
| A | PATENT ABSTRACTS OF JAPAN, vol. 7, no. 162 (E-187)[1307], 15 juillet 1983, page 104 E 187; & JP-A-58 70 601 (MITSUBISHI DENKI K.K.) 27-04-1983 * Résumé * | 1,2 | |
| A | FR-A-2 551 269 (LMT RADIO PROFESSIONNELLE) * Page 2, ligne 29 - page 3, ligne 21; figures 1,2 * | 1 | |
| A | PATENT ABSTRACTS OF JAPAN, vol. 10, no. 113 (E-339)[2170], 26 avril 1986, page 58 E 399; & JP-A-60 248 005 (FUJITSU K.K.) 07-12-1985 * Résumé * | 1 | DOMAINES TECHNIQUES RECHERCHES (Int. Cl.5) |
| A | EP-A-0 260 681 (WILHELM RUF AG) * Colonne 2, ligne 23 - colonne 3, ligne 16; figure 1 * | 1 | H 01 P H 01 R H 05 K |

Le présent rapport a été établi pour toutes les revendications

| Lieu de la recherche | Date d'achèvement de la recherche | Examinateur |
|---|---|---|
| LA HAYE | 30-11-1989 | DEN OTTER A.M. |